# EUROPEAN PATENT SPECIFICATION

(11) **EP 0 457 737 B1**
(45) Date of publication and mention of the grant of the patent: **20.11.1996**
(21) Application number: 91830206.8
(22) Date of filing: 17.05.1991
(51) Int. Cl.: H02H 9/04

(54) **MOS/BIP protection circuit**
MOS/BIP-Schutzschaltung
Circuit de protection MOS/BIP

(30) Priority: 18.05.1990 IT 4798590
(43) Date of publication of application: 21.11.1991
(73) Proprietor: TEXAS INSTRUMENTS INCORPORATED, Dallas Texas 75265 (US); TEXAS INSTRUMENTS ITALIA S.p.A., I-02015 Cittaducale (RI) (IT)
(72) Inventor: Talamonti, Luciano, I-02100 Rieti (IT); Marotta, Giulio, I-02100 Rieti (IT)
(74) Representative: Iannone, Carlo Luigi

(56) References cited:
- EP-A- 0 355 501
- EP-A- 0 401 410
- FR-A- 2 512 598
- FR-A- 2 630 867
- US-A- 3 407 339
- PATENT ABSTRACTS OF JAPAN vol. 8, no. 161 (E-257)(1598) 26 July 1984 & JP-A-59 061 169

## Description

This invention concerns a bipolar protection circuit, manufactured according to CMOS technology and more particularly compatible with the conventional 2um CMOS process, and having I/V characteristic curves similar to those of conventional Zener devices.

As is known, there are many devices and circuits having supply voltages which should be maintained during operation within strictly defined limits regardless of the current flowing therethrough, and which therefore should be protected against over-voltage effects. A well-known device adapted to perform such a protection function is the Zener diode; in fact, its characteristic discharge voltage - the so-called Zener voltage - as a function of the current flowing therethrough is sufficiently constant to provide a satisfactory protection effect: in practice, its I/V characteristic curve has the well-known profile which is ideally vertical, practically very steep and effectively nearly vertical.

It is also well known that a Zener device is not normally or at least satisfactorily manufacturable under the traditional CMOS technology; this means that it is not possible to manufacture in the same process self-protected CMOS integrated circuits, namely CMOS integrated circuits having a built-in protection device.

It is the object of this invention to eliminate this deficiency and more particularly, to make it possible to manufacture, rather than just a Zener structure, a circuit adapted to act as a Zener diode and having, therefore, a very steep and nearly vertical I/V characteristic curve.

FR-A-2512598 discloses a protection circuit for protecting an integrated circuit from overvoltages, parallel connected to the terminals of the circuit to be protected and comprising a series of components acting as Zener diodes, said components being of low power and being connected to the control electrode of a power component adapted to dissipate the power of said overvoltage. The main circuit of said power component is mounted in parallel to said terminals.

Japanese patent abstract, Vol. 8, Number 161 (E-257), 26.07.84 (JP-A-59 061 169) discloses a circuit to by-pass the high voltage of static electricity applied from an external input terminal through a p-n-p-n thyristor before the high voltage is applied to an internal circuit. The protective circuit comprises said thyristor and a resistor. The by-pass circuit also includes a transistor which is turned on by said thyristor in order to sink to ground said overvoltage.

EP-A-0 355 501 discloses a high current MOS-bipolar clamping circuit (Fig. 1) for use in a CMOS structure as a protection circuit, comprising a bipolar transistor defining an amplifying element and having a base, a collector and an emitter, the emitter communicating with a power source (EIN) to be stabilized, current from the power source being transmitted through said bipolar transistor when said bipolar transistor is conductive. Said transistor is adapted to be coupled via the collector thereof to the substrate of the CMOS structure as a parasitic element.

The principle upon which the circuit of this invention is based is to utilize the pibolar transistors that are always associated with the CMOS structures either as parasitic members (vertical transistors with collector materially coinciding with the substrate) or as implementable members (lateral transistors), if desired, in combination with a current MOS transistor.

The circuit as proposed by this invention comprises as basic components an amplifier member and a threshold member. The amplifier member comprises a bipolar transistor wherein the collector is connected to ground, the emitter is connected to the voltage to be stabilized and the base is connected to a reference voltage supplied by said threshold member. The threshold member, the reference voltage of which may also be of low quality, is implenented by means of a string of two or three cascade, diode-connected MOS transistors.

Such a circuit perfectly fulfills the desired objects because it has been found that its resulting characteristic curve corresponds to the characteristic curve of a conventional Zener diode.

It has also been found that a circuit of this kind is suitable for specialized circuitry, such as a Darlington pattern, when very high amplification figures are desired.

In a more preferred embodiment, the amplifier member is comprised of a two-collector, bipolar transistor having its emitter connected to the voltage to be stabilized, its base connected to the reference voltage furnished by said threshold member, its first collector connected to ground and its second collector connected to ground through a resistor and to the gate of a current MOS transistor inserted between ground and the line whose voltage is to be stabilized.

Further details and advantages of this invention will be made apparent by the following description with reference to the enclosed drawings wherein the preferred embodiments and the particular features of the working process are shown by way of illustration and not for limitative purposes.

In the drawings:
FIGURE 1 shows the basic implementation of the circuit having a threshold member comprising of three cascade, diode-connected MOS transistors;
FIGURE 2 shows the I/V characteristic curve of the circuit of FIGURE 1;
FIGURE 3 shows in overlapping representation the characteristic curves of (a) the threshold member alone, and (b) of the combination of a threshold member with the first embodiment of the amplifier member;
FIGURE 4 shows an embodiment comprising an amplifier (composite) transistor, with two lateral collectors and a vertical collector (to be considered as connected to the substrate, because it coincides therewith);
FIGURES 5a-b show the detailed design of the various stages of the CMOS process (in the case an N-TANK process) wherein such (composite) bipolar transistor is manufactured;
FIGURE 6 shows the electric diagram of such vertical and lateral, bipolar transistor, with all collectors connected to ground;
FIGURE 7 shows a Darlington connected circuit;
FIGURE 8 shows the combination of a threshold member as in FIGURE 1 with a two-collector, bipolar transistor (collector Cp = parasitic collector);
FIGURE 9 shows the circuit of this invention in its second embodiment; and
FIGURE 10 shows the I/V characteristic curve of the circuit of FIGURE 9.

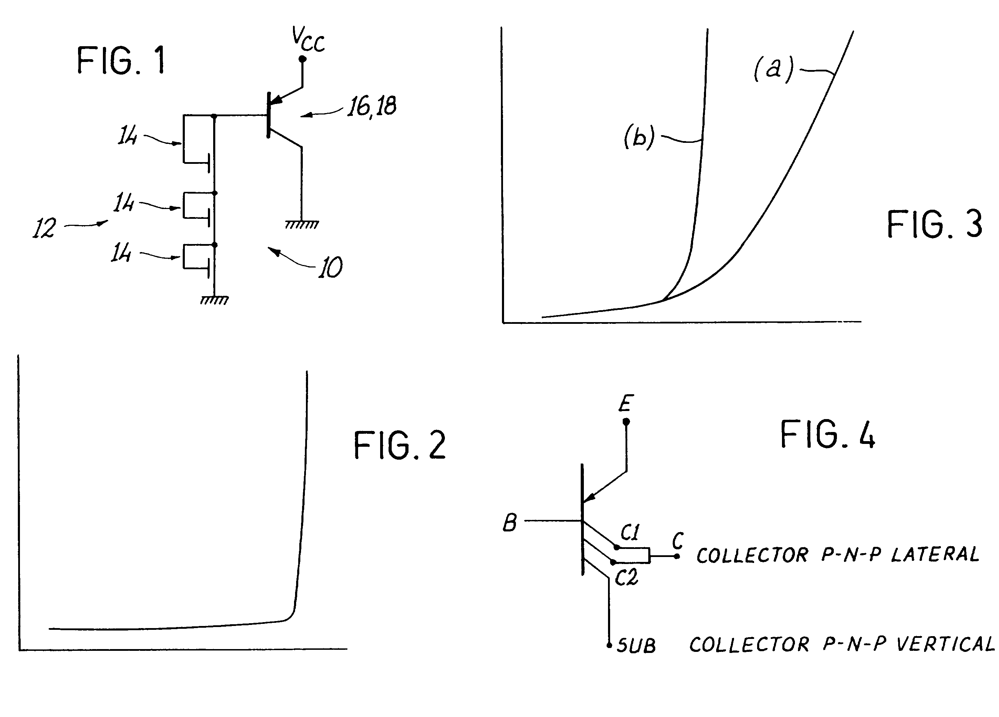

Referring now to FIGUREs 1-10, it can be observed that the circuit according to this invention comprises a threshold member that generates a reference voltage and is combined with an amplifier member such that when the voltage applied to the combined assembly is greater than the sum of the threshold voltage of the threshold member and of the voltage drop through the amplifier member, the current flow through the combined assembly is highly amplified at a nearly constant voltage.

When the circuit of this invention is examined from the I/V characteristic curve view point, it comprises a threshold member having per se an I/V characteristic curve that can also have a very slanted outline, combined with an amplifier member such that the resulting I/V characteristic curve of the combined assembly becomes very steep and nearly vertical, very similar to a Zener I/V characteristic curve.

The threshold member can be of any kind, such as one or more cascade, diode-connected, MOS or PMOS or NMOS transistors, a multiplier, etc. In a first embodiment, FIGURE 1, the amplifier member is merely a bipolar transistor, always appearing in MOS structures.

In FIGURE 1, therefore, a protection circuit 10 according to this invention is shown which comprises a threshold member 12 comprising of three cascade, diode-connected MOS transistors 14, interposed between ground and the base of a bipolar transistor 16 acting as an amplifier member 18. The emitter of such a bipolar transistor 16 is connected to the voltage V_{CC} to be stabilized and its collector is connected to ground.

The I/V characteristic curve of such a circuit is shown in FIGURE 2, which represents the noticeable amplification effect that can be achieved when the applied voltage becomes greater than a certain value that, in this case, is given by the sum of the threshold voltage of the threshold member 12 and of the V_{BE} voltage of the amplifier transistor.

In FIGURE 3, a comparison is shown between the outline (a) relating to the threshold member 12 alone and appearing rather poor and unsuitable to offer any protection from over voltages, and the outline (b) relating to the combined assembly of both members and the steepness of which nearly corresponds to the one of a Zener member and is guarantee of a safe protection.

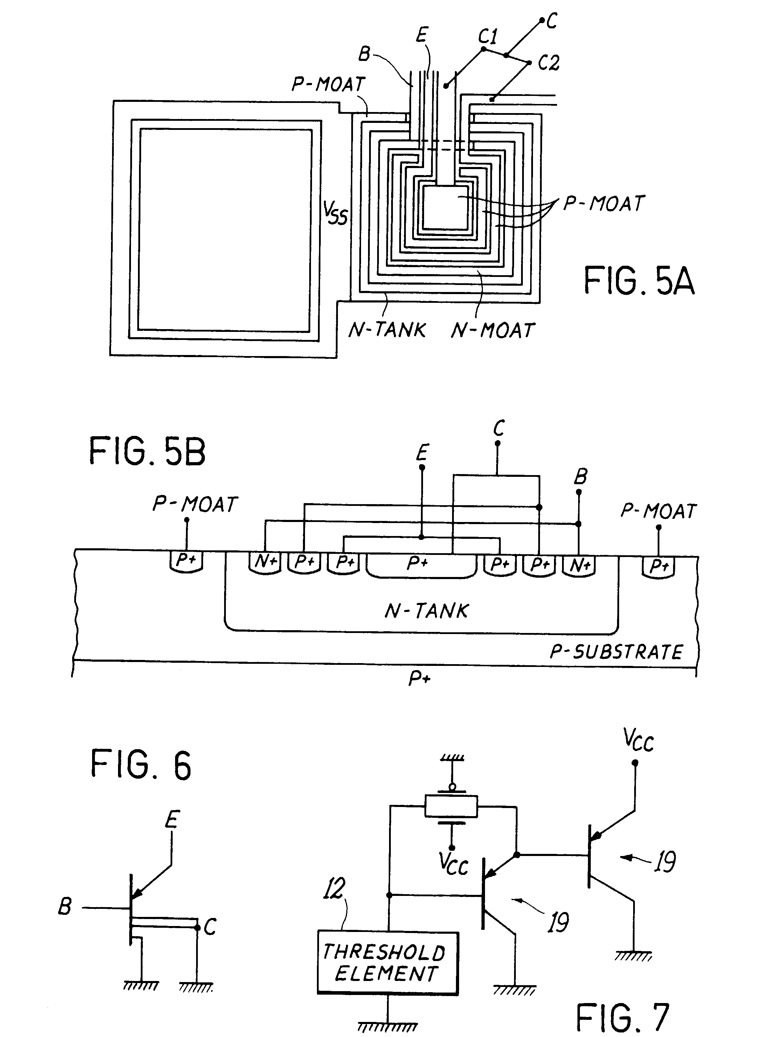

As far as the effective implementation is concerned, the amplifier member is implemented by exploiting the bipolar transistors 16 achievable in conventional MOS process. In particular, a composite transistor or double transistor is shown in FIGURE 4; more precisely, the combination is shown of a vertical PNP transistor having its collector coinciding with the substrate and of a lateral PNP transistor with double collector C1-C2. FIGUREs 5A-B shows the various design stages of a CMOS process in detail (in this case, a N-TANK process) by which the structure shown in FIGURE 4 can be achieved.

In view of the different capabilities of a vertical transistor (the gain is stable but a current flow exists through the substrate) and of a lateral transistor (lower gain, lower stability, but no current flow through the substrate), in each practical circumstance, it is to be ascertained whether the adoption of a lateral transistor according to FIGURE 6 is convenient or not.

Should the necessity exist of very high gain figures or when very low currents are needed with consequent low gain, a Darlington connection can be adopted as in FIGURE 7, in order to obtain a gain figure which is the product of the gain figure of the two component transistors 19.

It has been found that the structure as heretofore disclosed works perfectly when the involved currents are low, but it does not offer correspondingly good performances when high currents are involved, in spite of the fact that the dynamic resistance lowers as the current increases. This is substantially due to the fact that, in the conventional CMOS technology, no buried layer is available as it usually occurs in bipolar structures to reduce the parasitic resistor effects.

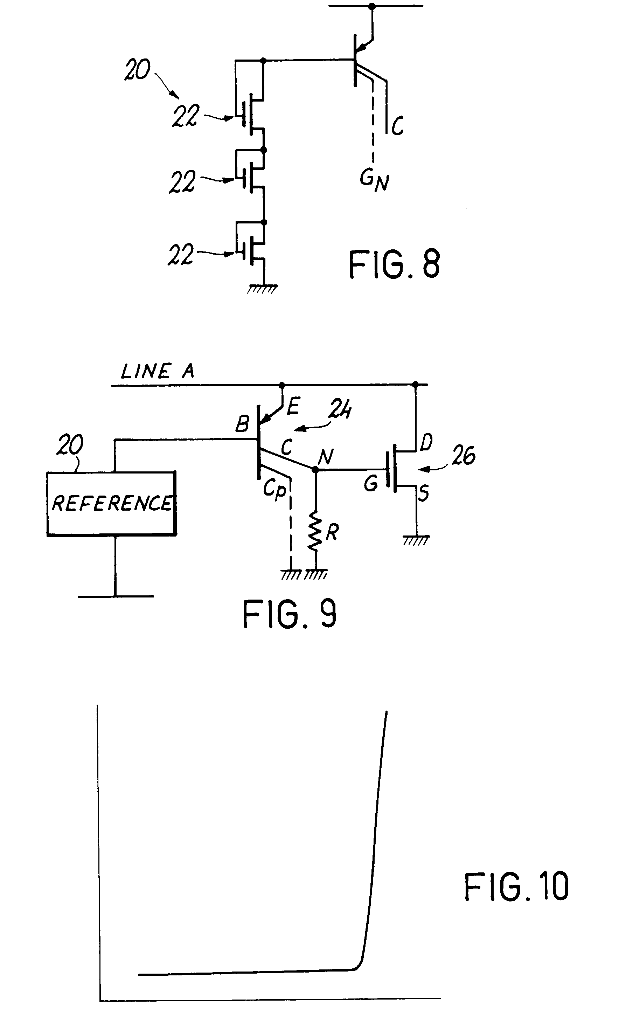

This requirement is fulfilled by the embodiment of FIGURE 9, which also includes a reference member 20 (that can be made, as in the first embodiment, by three drain-gate diode-connected, N-channel, MOS transistors 22, as in FIGURE 8) and an amplifier member comprising of a bipolar transistor 24, as in the first embodiment, but having two collectors, and of a N-channel 26, MOS transistor.

In particular, the bipolar transistor has its base B connected to the reference voltage, its emitter E connected to the line whose voltage is to be stabilized, a parasitic collector C_{P} connected to ground and a collector C connected to ground through a resistor R and to the gate G of said N-channel MOS transistor 26. The N-channel MOS transistor in turn is inserted with its drain and source regions between the line whose voltage is to be stabilized and ground.

The operation details are as follows. Collector C of said bipolar transistor effectively operates as a current sensor such that, when a current flows therethrough, the voltage of node N increases until the current MOS transistor is set to its conductive condition.

More particularly, as soon as the line to be protected reaches a voltage value which is higher by V_{BE} than the reference voltage, a collector current starts to flow through collector C of the bipolar transistor and the resistor R.

As soon as the voltage drop generated through this resistor becomes higher than the threshold voltage of N-channel transistor 26, this starts to be conductive and a noticeable current increase occurs according to the very steep characteristic curve of FIGURE 10.

The preferred embodiments of this invention have been heretofore described, but it should be understood that those skilled in the art can make changes and variations without departing from the scope of this invention.

## Claims

1. A high current MOS-bipolar clamping circuit in a CMOS structure as a protection circuit, said clamping circuit comprising:
threshold means (12; 20) for providing a reference voltage,
a bipolar transistor (16; 24) defining an amplifying element (18) and having a base, collector and an emitter, the emitter communicating with a power source (Vcc) to be stabilized,
said threshold means (12; 20) being connected to the base of said bipolar transistor (16; 24) for providing the reference voltage thereto to render said bipolar transistor conductive, and
current from the power source being transmitted through said bipolar transistor when said bipolar transistor is conductive; whereby said threshold means (12, 20) comprises a plurality of MOS transistors (14; 22) connected in cascade as diodes, and said bipolar transistor (16; 24) is adapted to be coupled via the collector thereof to the CMOS structure as a parasitic element, said bipolar transistor being effective to significantly amplify the current transmitted through said bipolar transistor while maintaining the voltage developed at said bipolar transistor at a substantially constant magnitude when the voltage applied thereto from the power source is greater than the sum of the reference voltage provided by said plurality of MOS transistors connected in cascade as diodes and the base emitter voltage of said bipolar transistor to produce a substantially vertical current/voltage characteristic similar to that of a Zener diode device.

2. A clamping circuit as set forth in Claim 1, further characterized in that said bipolar transistor (16; 24) is a vertical bipolar transistor present in the CMOS structure and having its collector provided by the substrate of the CMOS structure.

3. A clamping circuit as set forth in Claim 1, further characterized in that said amplifying element (18) is defined by a vertical bipolar transistor adapted to be coupled to a CMOS structure as a parasitic element and a lateral bipolar transistor present in the CMOS structure.

4. A clamping circuit as set forth in Claim 3, further characterized in that the collector of the vertical bipolar transistor is defined by the substrate (SUB) of the CMOS structure, and the collector (C) of said lateral bipolar transistor is provided as a dopant region defined in the substrate of the CMOS structure.

5. A clamping circuit as set forth in Claim 1, further characterized in that said bipolar transistor is a vertical bipolar transistor including a multiple collector (C1, C2) one of the collectors of the multiple collector of said vertical bipolar transistor being defined by the substrate of the CMOS structure of which said vertical bipolar transistor exists are a parasitic element

6. A damping circuit as set forth in Claim 1, further characterized in that the amplifying element (18) is defined by first and second bipolar transistors (19, 19) respectively having a base, collector and emitter and being arranged in a Darlington configuration.

7. A clamping circuit as set forth in Claim 1, further characterized in that the bipolar transistor (24) comprising said amplifier has first and second collectors (C, Cp), said bipolar transistor being coupled to said threshold means (20) for enabling a current path between the first node (LINEA) and a second node (N) in response to the first node exceeding a predetermined voltage, the first collector (C) of said bipolar transistor (24) being coupled to said second node, the second collector (Cp) of said bipolar transistor (24) being coupled to ground and a resistor (R) being interposed in the connection between said first collector of said bipolar transistor and ground, and further including a MOS transistor (26) driven by the first collector (C) of said bipolar transistor (24) to conduct current between said first and second nodes.

8. A CMOS structure having a high current MOS-bipolar clamping circuit provided therein as a protection circuit, said CMOS structure comprising:
a semiconductor substrate,
complementary MOS transistors defined in said semiconductor substrate;
characterized in that said high current MOS-bipolar clamping circuit as provided therein is in accordance with the clamping circuit as set forth in any of the preceding claims.

## Patentansprüche

1. Hochstrom-MOS-Bipolar-Klemmschaltung in einer CMOS-Struktur als Schutzschaltung, wobei die Klemmschaltung enthält:
Schwellenvertmittel (12; 20) zum Liefern einer Referenz-spannung,
einen bipolaren Transistor (16; 24), der ein Verstärkungselement (18) bildet, und eine Basis, einen Kollektor und einen Emitter aufweist, wobei der Emitter mit einer zu stabilisierenden Versorgungsquelle (V) in Verbindung steht,
wobei die Schwellenwertmittel (12; 20) mit der Basis des bipolaren Transistors (16; 24) verbunden sind, um die Referenzspannung daran anzulegen, damit der bipolare Transistor leitend gemacht wird, und
wobei Strom aus der Versorgungsquelle über den bipolaren Transistor übertragen wird, wenn dieser bipolare Transistor leitet;
wobei die Schwellenwertmittel (12; 20) mehrere MOS-Transistoren (14; 22) enthält, die als Dioden in Kaskade geschaltet sind und der bipolare Transistor (16; 24) über seinen Kollektor mit der CMOS-Struktur als parasitäres Element gekoppelt werden kann, wobei der bipolare Transistor bewirkt, das der durch diesen bipolaren Transistor übertragene Strom beträchtlich verstärkt wird, während die an diesen bipolaren Transistor entwickelte Spannung auf einen im wesentlichen konstanten Wert gehalten wird, wenn die an ihn angelegte Spannung aus der Versorgungsquelle größer als die Summe aus der von den mehreren MOS-Transistoren, die als Dioden in Kaskade geschaltet sind, gelieferten Referenzspannung und der Basis-Emitter-Spannung des bipolaren Transistors ist, damit eine im wesentlichen vertikale Strom/Spannungs-Kennlinie ähnlich der einer Zehner-Diodenvorrichtung erzeugt wird.

2. Klemmschaltung nach Anspruch 1, ferner dadurch gekennzeichnet, daß der bipolare Transistor (16; 24) ein vertikalen bipolarer Transistor ist, der in der CMOS-Struktur vorharden ist und dessen Kollektor vom Substrat der CMOS-Struktur gebildet ist.

3. Klemmschaltung nach Anspruch 1, ferner dadurch gekennzeichnet, daß das verstärkende Element (18) von einem vertikalen bipolaren Transistor, der als parasitäres Element mit einer CMOS-Struktur gekoppelt werden kann, und einem lateralen bipolaren Transistor, der in der CMOS-Struktur vorhanden ist, gebildet ist.

4. Dämpfungsschaltung nach Anspruch 3, ferner dadurch gekennzeichnet, daß der Kollektor des vertikalen bipolaren Transistors durch das Substrat (SUB) der CMOS-Struktur gebildet ist und der Kollektor (C) des lateralen bipolaren Transistors als eine Dotierungszone in Substrat der CMOS-Struktur gebildet ist.

5. Dämpfungsschaltung nach Anspruch 1, ferner dadurch gekennzeichnet, das der bipolare Transistor ein vertikaler bipolarer Transistor mit einem Vielfachkollektor (C1, C2) ist, wobei einer der Kollektoren des Mehrfachkollektors des vertikalen bipolaren Transistors durch das Substrat der CMOS-Struktur gebildet ist, von der der vertikale bipolare Transistor als parasitäres Element vorhanden ist.

6. Klemmschaltung nach Anspruch 1, ferner dadurch gekennzeichnet, daß das verstärkende Element (18) durch erste und zweite bipolare Transistoren (19, 19) mit jeweils einer Basis, einem Kollektor und einem Emitter gebildet ist, die in einer Darlington-Schaltung verbunden sind.

7. Klemmschaltung nach Anspruch 1, ferner dadurch gekennzeichnet, daß der bipolare Transistor (24), der den Verstärken bildet, erste und zweite Kollektoren (C, Cp) aufweist, wobei der bipolare Transistor mit den Schwellenvertmitteln (20) gekoppelt ist, um einen Stromweg zwischen dem ersten Schaltungspunkt (LINEA) und einem zweiten schaltungspunkt (N) als Reaktion darauf freizugeben, daß der erste Schaltungspunkt eine vorbestimmte Spannung übersteigt, wobei der erste Kollektor (C) des bipolaren Transistors (24) mit dem zweiten Schaltungspunkt gekoppelt ist, der zweite Kollektor (Cp) des bipolaren Transistors (24) mit Masse gekoppelt ist und ein Widerstand (R) in die Verbindung zwischen dem ersten Kollektor des bipolaren Transistors und Masse eingefügt ist, und wobei ferner ein MOS-Transistor (26) enthalten ist, der durch den ersten Kollektor (C) des bipolaren Transistors (24) angesteuert ist, um Strom zwischen dem ersten und dem zweiten Schaltungspunkt zu leiten.

8. CMOS-Struktur mit einer darin an Schutzschaltung vorgesehenen Hochstrom-MOS-Bipolar-Klemmschaltung, wobei die CMOS-Struktur enthält:
ein Halbleitersubstrat,
komplementäre MOS-Transistoren, die in dem Halbleitersubstrat gebildet sind;
dadurch gekennzeichnet, daß die darin vorgesehene Hochstrom-MOS-Bipolar-Klemmschaltung der Klemmschaltung nach einem der vorhergehenden Ansprüche entspricht.

## Revendications

1. Circuit bipolaire MOS de nivellement de tension à courant élevé, dans une structure CMOS, en tant que circuit de protection, ledit circuit de fixation de niveau comprenant:
un moyen (12; 20) à seuil pour fournir une tension de référence,
un transistor bipolaire (16; 24) définissant un élément d'amplification (18) et comportant une base, un collecteur et un émetteur, l'émetteur communiquant avec une source d'alimentation (V_{CC})destinée à être stabilisée,
ledit moyen (12; 20) à seuil étant connecté à la base dudit transistor bipolaire (16; 24) - pour lui appliquer la tension de référence afin de rendre conducteur ledit transistor bipolaire, et
le courant en provenance de la source d'alimentation étant transmis par l'intermédiaire dudit transistor bipolaire lorsque ledit transistor bipolaire est conducteur;
dans lequel ledit moyen (12; 20) à seuil comprend une pluralité de transistors MOS (14; 22) connectés en cascade comme des diodes, et ledit transistor bipolaire (16; 24) est apte à être couplé par l'intermédiaire de son collecteur à la structure CMOS en tant qu'élément parasite, ledit transistor bipolaire étant efficace pour amplifier de manière significative le courant transmis par l'intermédiaire dudit transistor bipolaire tout en maintenant la tension développée au niveau dudit transistor bipolaire à une amplitude sensiblement constante lorsque la tension qui lui est appliquée par la source d'alimentation est supérieure à la somme de la tension de référence fournie par ladite pluralité de transistors MOS connectés en cascade comme des diodes et la tension base-émetteur dudit transistor bipolaire, afin de produire une caractéristique courant/tension sensiblement verticale, similaire à celle d'un dispositif à diode Zener.

2. Circuit de nivellement de tension selon la revendication 1, caractérisé en outre en ce que ledit transistor bipolaire (16; 24) est un transistor bipolaire vertical présent dans la structure CMOS et ayant son collecteur constitué par le substrat de la structure CMOS.

3. Circuit de nivellement de tension selon la revendication 1, caractérisé en outre en ce que ledit élément d'amplification (18) est défini par un transistor bipolaire vertical apte à être couplé à une structure CMOS en tant qu'élément parasite et un transistor bipolaire latéral présent dans la structure CMOS.

4. Circuit de nivellement de tension selon la revendication 3, caractérisé en outre en ce que le collecteur du transistor bipolaire vertical est défini par le substrat (SUB) de la structure CMOS, et le collecteur (C) dudit transistor bipolaire latéral se présente sous la forme d'une région de dopant définie dans le substrat de la structure CMOS.

5. Circuit de nivellement de tension selon la revendication 1, caractérisé en outre en ce que ledit transistor bipolaire est un transistor bipolaire vertical comportant des collecteurs multiples (C1, C2), l'un des collecteurs multiples dudit transistor bipolaire vertical étant défini par le substrat de la structure CMOS dont ledit transistor bipolaire vertical se présente sous la forme d'un élément parasite.

6. Circuit de nivellement de tension selon la revendication 1, caractérisé en outre en ce que l'élément d'amplification (18) est défini par des premier et second transistors bipolaires (19, 19) comportant respectivement une base, un collecteur et un émetteur, et étant disposés selon une configuration de Darlington.

7. Circuit de nivellement de tension selon la revendication 1, caractérisé en outre en ce que le transistor bipolaire (24) comprenant ledit amplificateur comporte des premier et second collecteurs (C, Cp), ledit transistor bipolaire étant couplé audit moyen (20) à seuil pour permettre le passage d'un courant entre un premier noeud (LINE A) et un second noeud (N) en réponse au fait que le premier noeud excède une tension prédéterminée, le premier collecteur (C) dudit transistor bipolaire (24) étant couplé audit second noeud, le second collecteur (Cp) dudit transistor bipolaire (24) étant couplé à la masse et une résistance (R) étant interposée dans la connexion entre ledit premier collecteur dudit transistor bipolaire et la masse, et comportant en outre un transistor MOS (26) commandé par le premier collecteur (C) dudit transistor bipolaire (24) pour acheminer le courant entre lesdits premier et second noeuds.

8. Structure CMOS comportant un circuit bipolaire MOS de nivellement de tension à courant élevé disposé dans celle-ci en tant que circuit de protection, ladite structure CMOS comprenant:
un substrat à semiconducteur,
des transistors MOS complémentaires définis dans ledit substrat à semiconducteur;
caractérisée en ce que ledit circuit de fixation de niveau bipolaire MOS à courant élevé tel qu'utilisé ici est conforme au circuit de nivellement de tension tel que défini dans l'une quelconque des revendications précédentes.
